(19) **Europäisches Patentamt**

**European Patent Office**

**Office européen des brevets**

(11) **EP 1 300 686 B1**

(12) **EUROPÄISCHE PATENTSCHRIFT**

(45) Veröffentlichungstag und Bekanntmachung des Hinweises auf die Patenterteilung:
**02.11.2006 Patentblatt 2006/44**

(51) Int Cl.:
*G01R 15/18* (2006.01)   *G01R 19/00* (2006.01)
*G01R 19/25* (2006.01)

(21) Anmeldenummer: **02019609.3**

(22) Anmeldetag: **03.09.2002**

(54) **Verfahren und Einrichtung zur Stromwertermittlung unter Einsatz eines Stromwandlers, welcher im Bereich der Kernsättigung arbeitet**

Method and device for determining current value using a current transformer which operates in the saturation region

Procédé et dispositif de détermination de la valeur du courant utilisant un transformateur de courant qui fonctionne dans la région de la saturation

(84) Benannte Vertragsstaaten:
**DE FR GB IT**

(30) Priorität: **02.10.2001 DE 10148815**

(43) Veröffentlichungstag der Anmeldung:
**09.04.2003 Patentblatt 2003/15**

(73) Patentinhaber: **ABB PATENT GmbH**
**68526 Ladenburg (DE)**

(72) Erfinder: **Lau, Waldemar, Dipl.-Ing.(FH)**
**68766 Hockenheim (DE)**

(74) Vertreter: **Miller, Toivo et al**
**ABB Patent GmbH**
**Postfach 1140**
**68520 Ladenburg (DE)**

(56) Entgegenhaltungen:
DE-A- 2 704 337     DE-A- 3 912 542
DE-A- 4 326 538     DE-A- 19 802 831
US-A- 3 846 675     US-A- 6 040 689

• TIETZE, SCHENK: "Halbleiterschaltungstechnik" 1993 , SPRINGER VERLAG , BERLIN XP002274203 10. Ausgabe, ISBN: 3-540-56184-6, Seite 876-880 * Abbildungen 25.34,,25.35 *

EP 1 300 686 B1

**Beschreibung**

Die Erfindung bezieht sich auf ein Verfahren und eine Einrichtung zur Stromwertermittlung unter Einsatz eines Stromwandlers, welcher im Bereich der Kernsättigung arbeitet.

In elektrischen Stromkreisen, wie beispielsweise beim Anlaufen von Motoren treten häufig Überströme auf, die entweder zur Anzeige gebracht werden oder zum Abschalten elektronischer Motorschutz- und Steuergeräte genutzt werden, wobei diese Geräte einstellbare Motorklassen aufweisen mit denen die Nennstromwerte und Schutzklassen eingestellt werden. Mittels eines Stromwandlers werden Nennstrom, aber auch Überstrom genau erfaßt, um beispielsweise mikroprozessor- gesteuerten elektronischen Baugruppen zur Verfügung zu stehen, die diese Stromwerte weiterverarbeiten.

Bekannt sind die Motorschutz- und Steuergeräte SIMOCODE-DP 3UF5 der Firma Siemens, die Stromwandler für diese Geräte zur Aufnahme des Nennstromes bei gleichzeitiger Erfassung des Überstromes einsetzen. Diese Geräte weisen entsprechend ihrer im Katalog "Siemens Niederspannungs-Schalttechnik NS K - 1999/2000, aufgeführten Stromeinstellbereiche einen Stromerfassungsbereich von ca. 1 zu 40 auf, wobei bei einem Motor- Überstrom des zehnfachen Nennstromes ($I_{Nenn}$) nur noch enge Bereiche für die Motornennströme zur Verfügung stehen.

Aus diesem Grund werden mehrere verschiedene Gerätetypen angeboten, um ein vom Anwender üblicherweise gefordertes Motorstromspektrum im Bereich von ca. 0,2A bis 63 A abzudecken.

Der Nachteil der kompensierten Stromwandler ergibt sich aus einem hohen elektrischen bzw. elektronischen Schaltungsaufwand und der Verwendung zusätzlicher Wandlerwicklungen. Durch die Kompensation wird außerdem bei hohen Motorströmen zusätzliche Verlustwärme erzeugt. Zur Herstellung dieser Geräte ist eine hohe mechanische Präzision erforderlich, was einen hohen Gerätepreis bedingt. Aus diesen Gründen werden diese Geräte weitgehend nur zur Nachrüstung auf Grund eines vertretbaren Installationsbedarfs oder für Motoren mit großer Leistung eingesetzt.

In der DE 27 04 337 ist ein Überstromschutzgerät für einen Wechselstrommotor mit einem Stromwandler beschrieben, dessen Sekundärwicklung eine von dem in der Anschlussleitung fließenden Strom abhängige Wechsel-Ausgangsgröße abgibt, welche eine Auslöseschaltung zum Ausschalten des Motors ansteuert. Mittels einer im Überstromrelais integrierten Schaltung wird die Größe des Stromes überwacht. Dabei werden die Stromwandler teilweise in Sättigung betrieben.

Aus Tietze /Schenk: "Halbleiterschaltungstechnik", 10. Auflage / Springer Verlag (ISBN: 3-540-56184-6), Seite 876-880, sind verschiedene Schaltungen zur Messung eines Scheitelwertes bekannt.

Der Erfindung liegt daher die Aufgabe zugrunde, ein Verfahren sowie eine Einrichtung zur Stromwertermittlung mittels eines Stromwandlers anzugeben, wobei ein wesentlich größerer Stromerfassungsbereich bei gleicher Wandlergröße abgedeckt wird.

Diese Aufgabe wird durch ein Verfahren zur Stromwertermittlung unter Einsatz eines Stromwandlers, welcher im Bereich der Kernsättigung arbeitet mit den im Anspruch 1 angegebenen Merkmalen gelöst. Eine Einrichtung zur Durchführung dieses Verfahrens und vorteilhafte Ausgestaltungen sind in weiteren Ansprüchen angegeben.

Ausgehend davon, daß der Strom eines Motors durch die Kreisbewegung des Rotors oder durch den hohen induktiven Anteil in der Anlaufphase, bedingt durch die Streuinduktivität infolge des Luftspaltes eine Integration erfährt, ergibt sich eine Kreisfunktion für den Motorstrom. Das ist auch der Fall, wenn die Ansteuerung des Motors mit Spannungsimpulsen wie beispielsweise bei Frequenzumrichtem erfolgt. Der Verlauf des Motorstroms ist sowohl bei Einphasenmotoren als auch bei Drehstrommotoren sinusförmig.

Bedingt durch ihren Aufbau werden Stromwandler als Transformatoren betrachtet, bei denen die Wicklungen aus wenigen Primärwindungen und einer großen Anzahl von Sekundärwindungen bestehen, wobei sie einen Primärstrom $I_{prim}$ im Verhältnis der Windungszahlen zwischen Primär- und Sekundärwicklungen auf einen Sekundärstrom $I_{sek}$ übersetzen, der dann als Spannungsabfall von einem Meßgerät oder einer digitalen Signalverarbeitungsschaltung erfaßt wird. Auch verhält sich der magnetische Fluß $\Phi$ im Magnetkern proportional zum Primärstrom $I_{prim}$.

Das Spannungsverhalten läßt sich wie folgt beschreiben:
Aus der Lenzschen Regel, nach der sich der Induktionsstrom immer so einstellt, daß er der Ursache entgegenwirkt, ergibt sich, daß die magnetischen Felder, die durch die beiden Wicklungen im Magnetkern erzeugt werden einander entgegengesetzt gerichtet sind. Der im Wandlerkern erzeugte magnetischer Fluß $\Phi$ induziert demzufolge eine Sekundärspannung $U_{sek}$.

Die durch den Primärstrom $I_{prim}$ in der Sekundärwicklung indizierte Spannung $U_{sek}$ ergibt sich nach folgender Beziehung:

$$U_{sek} = - d\Phi / dt, \quad \text{wobei } \Phi \sim I_{prim} \text{ und } d\Phi / dt \text{ die Flußänderung ist.}$$

Die Spannung $U_{sek}$ folgt dem Primärstrom $I_{prim}$ in einer Cosinusfunktion, d.h. um 90° phasenverschoben. Demzufolge erreicht die Sekundärspannung $U_{sek}$ ihren Maximalwert, wenn der Primärstrom $I_{prim}$ und damit der prägende Fluß $\Phi_{prim}$ den Nulldurchgang kreuzt, denn hier ist die Flußänderung $d\Phi/dt$ am größten. In diesem Bereich befindet sich der Magnetkern nicht in der Sättigung. Der induzierte Spannungsspitzenwert ist demzufolge mathematisch korrekt ein Abbild zum Spitzenwert des induzierenden Primärstromes $I_{prim}$, und zwar nacheilend um 90° phasenverschoben.

Ein hoher Anstieg des Primärstromes $I_{prim}$ bewirkt, daß der Magnetkern in Sättigung geht und der Sekundärkreis periodisch für ein Zeitintervall in Leerlauf gesetzt wird.

Die Sekundärspannung $U_{sek}$ beidseitig zum Spitzenwert beschreibt für einen bestimmten Winkel eine sinusförmige Kreisfunktion. Dieser Winkel wird von den Sättigungspunkten des Magnetkernes gemäß der Hysteresekurve bzw. der Magnetisierungskennlinie bestimmt. Mit steigendem Primärstrom $I_{prim}$ verringert sich dieser Winkel, und die induzierte Spannung wird immer impulsförmiger. Die Impulsfläche wird bestimmt durch die Spannungszeitfläche des verwendeten Magnetkerns.

Die in der Sekundärwicklung induzierte Spannung erzeugt einen 90° nacheilenden Strom in der Induktivität, der an einem zur Sekundärwicklung parallelgeschalteten Meßwiderstand ein entsprechendes Signal für die elektronische Weiterverarbeitung erzeugt.

Durch die Erweiterung des Stromerfassungsbereiches mittels der Arbeitsweise des Stromwandlers im Bereich der Kernsättigung ergeben sich nachfolgend aufgeführte Vorteile.

Bei gleichen Anforderungen an den Stromerfassungsbereich können kleinere, leichtere und kostengünstigere Stromwandler entwickelt werden, oder aber es kann ein wesentlich größerer Stromerfassungsbereich bei gleicher Wandlergröße erfaßt werden.

Das erfindungsgemäße Verfahren ermöglicht es auch, eine geringere Verlustleistung und damit eine geringere Temperatur in den Wandlerwicklungen und im Meßwiderstand bedingt durch die Kurvenform des Sekundärstroms infolge der Kernsättigung zu erreichen.

Eine weitere Beschreibung der Erfindung erfolgt anhand der Ausführungsbeispiele, die in den folgenden Zeichnungsfiguren näher erläutert sind.

Es zeigen:

Fig. 1     eine Darstellung der Stromverläufe in Abhängigkeit von der Sättigung des Magnetkerns,

Fig. 2     einen Stromwandler, der die Verarbeitung des Sekundärstrom der sekundären Induktivität mit einem Mikrocontroller durchführt, und

Fig. 3     einen Stromwandler, der den Ausgangsstrom der sekundären Wicklung einem Sample & Hold- Bausteins zuführt.

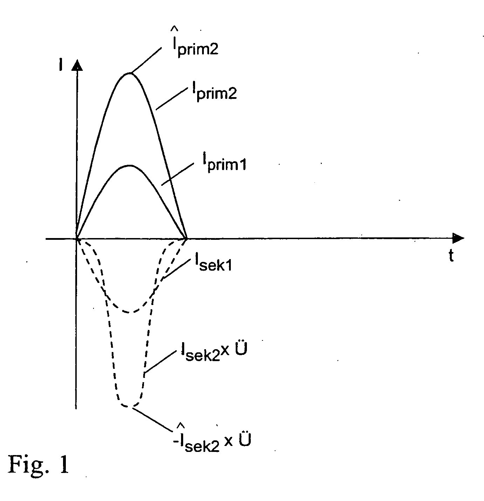

In Fig. 1 sind die Verläufe von Primärstrom $I_{prim}$ und Sekundärstrom $I_{sek}$ bei der Arbeitsweise des Stromwandlers im Bereich eines ungesättigten bzw. eines gesättigten Magnetkernes aufgezeigt. Für den Primärstrom $I_{prim}$ und den Sekundärstrom $I_{sek}$ des Stromwandlers gilt für die Spitzen- bzw. Scheitelwerte folgende Beziehung:

$$\hat{I}_{prim} = -\hat{I}_{sek} * \ddot{U}$$

$\ddot{U}$ = Übersetzungsverhältnis zwischen Primär- und Sekundärwicklung, $I_{sek}$ = Spitzen- bzw. Scheitelwert des Sekundärstromes

mit:

$$\hat{I}_{prim2} = -\hat{I}_{sek2} * \ddot{U}$$

Davon ausgehend, daß der Phasenstrom in einem Drehstromelektromotor eine Kreisfunktion beschreibt, gilt für die Spitzen- bzw. Scheitelwerte von Strom und Spannung folgende Beziehung:

$$\hat{I} = I_{eff} * \sqrt{2} \qquad \longrightarrow \qquad I_{eff} = \hat{I} / \sqrt{2} * \ddot{U}$$

$$\hat{U} = U_{eff} * \sqrt{2} \qquad \longrightarrow \qquad U_{eff} = \hat{U} / \sqrt{2}$$

Daraus ergibt sich der nachfolgende Effektivwert des gemessenen Phasenstromes $I_{eff}$ bei gesättigtem Magnetkern mit $I_{sek2} * Ü$:

$$I_{eff} = \hat{I}_{sek2} / \sqrt{2} * Ü$$

Dieser Effektivwert des Stromes wird nun zur Weiterverarbeitung bzw. Anzeige genutzt.

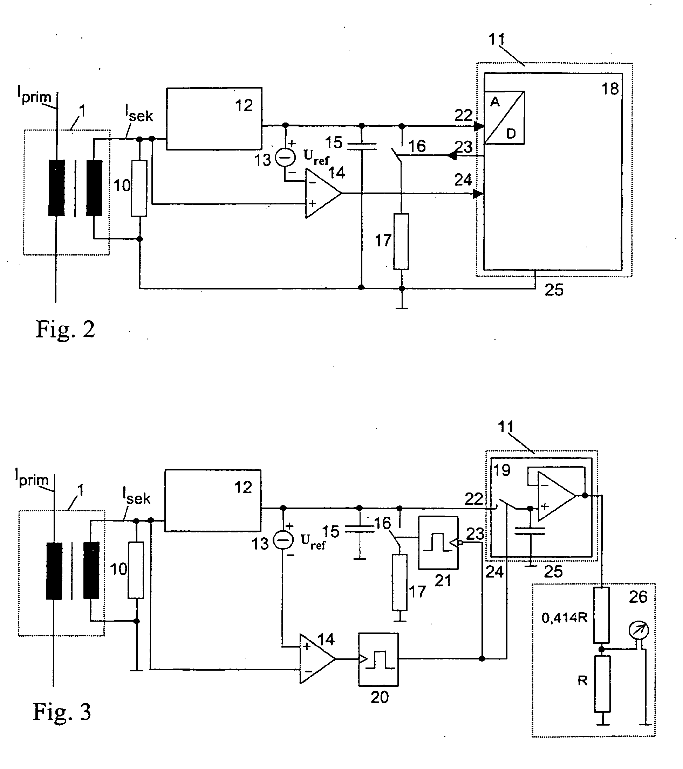

Die in Fig. 2 dargestellte erfindungsgemäße Einrichtung zur Stromwertermittlung, die einen Stromwandler 1 enthält, der durch Transformation den Primärstrom $I_{prim}$ mit einem bestimmten Übersetzungsverhältnis Ü zwischen Primär- und Sekundärwicklung in einen Sekundärstrom $I_{sek}$ umwandelt, weist im Sekundärzweig eine Gleichrichterschaltung und einen parallel zur Sekundärwicklung angeschlossenen Meßwiderstand 10 auf. Dabei wird ein Spitzen- bzw. Scheitelwert beispielsweise einer positiven Halbwelle mittels eines Spitzenwertgleichrichters 12, der vorzugsweise ein Präzisionsgleichrichter ist, ermittelt und in einem Speicherelement 15, was vorzugsweise ein Speicherkondensator ist, zur Weiterverarbeitung gespeichert.

Mittels eines Komperators 14, der seine Referenzspannung $U_{ref}$ aus einer Referenzspannungsquelle 13 bezieht, wird das Überschreiten des Spitzen- bzw. Scheitelwertes der Halbwelle detektiert und der Komperator 14 gibt ein Interrupt- Signal an einen Eingang 24 einer Signalverarbeitungseinheit 11, die beispielsweise einen Mikrocontroller 18 enthält, weiter um somit den Mikrocontroller 18 zu aktivieren.

Neben dem Eingang 24 für das Interrupt- Signal hat der Mikrocontroller 18 einen weiteren Eingang 25 für das Massepotential.

Ein Analog/Digital- Wandler, welcher im Mikrocontroller 18 integriert ist, übernimmt an einem Eingang 22 den im Speicherkondensator 15 gespeicherten Spitzen- bzw. Scheitelwert der Halbwelle und verarbeitet diesen Wert weiter. Der digitalisierte Wert wird dann beispielsweise zur Berechnung einer Motorschutzfunktion weiterverwendet.

Nach Übernahme des Spitzen- bzw. Scheitelwertes und dessen erfolgter Digital/ Analog- Wandlung gibt der Mikrocontroller 18 an einem Ausgang 23 einen RESET- Impuls an eine Schaltvorrichtung 16 aus. Der Schaltvorrichtung 16 ist ein Widerstand 17 zur Strombegrenzung in Reihe geschaltet.

Die Schaltvorrichtung 16, die zum Speicherkondensator 15 parallelgeschaltet ist, schließt nun kurzzeitig und bewirkt, daß der Speicherkondensator 15 entladen wird. Damit ist die Einrichtung zur Erfassung eines nächsten Spitzen- bzw. Scheitelwertes bereit.

In Fig. 3 erfolgt die Spitzenwerterfassung einer positiven Halbwelle wie in Fig. 2 ebenfalls mittels der Spitzenwertgleichrichtung.

Dabei ist dem Komperator 14 ein erster Impulsgeber 20 nachgeschaltet, welcher mit der positiven Flanke des Komperators 14 getriggert wird.

Mit der positiven Ausgangsflanke des ersten Impulsgebers 20 erhält die Signalverarbeitungseinheit 11, welche als Sample & Hold- Baustein 19 ausgeführt ist, am Eingang 24 den Befehl, den im Speicherkondensator 15 gespeicherten Spitzen- bzw. Scheitelwert in den Sample & Hold- Baustein 19 am Eingang 22 zu übernehmen.

Die negative Flanke des ersten Impulsgebers 20 wird einem nachgeschalteten zweiten Impulsgeber 21 am Eingang 23 zeitverzögert zugeführt, wodurch der zweite Impulsgeber 21 ein kurzzeitiges Schließen der dem Speicherkondensator 15 parallelgeschalteten Schaltvorrichtung 16 bewirkt. Dadurch wird der Speicherkondensator 15 entladen und die Bereitschaft der Einrichtung für die Erfassung des nächsten Spitzen- bzw. Scheitelwertes hergestellt. Der Schaltvorrichtung 16 ist dabei ebenfalls ein Widerstand 17 zur Strombegrenzung in Reihe geschaltet.

Der Ausgangswert des Sample & Hold- Bausteins 19 wird beispielsweise nach einer Division durch $\sqrt{2}$ über einen Spannungsteiler für die Effektivwertanzeige in einer Effektivwertanzeigeeinrichtung 26 genutzt.

Bezugszeichenliste

1    Stromwandler

4

| 10 | Strom- Meßwiderstand |
|----|----|
| 11 | Signalverarbeitungseinheit |
| 12 | Spitzenwertgleichrichter |
| 13 | Referenzspannungsquelle mit $U_{Referenz} > U_{offset}$ am Komperator |
| 14 | Komperator |
| 15 | Speicherelememt, Speicherkondensator |
| 16 | Schaltvorrichtung |
| 17 | Strombegrenzungswiderstand |
| 18 | Mikrocontroller mit A/D- Wandler |
| 19 | Sample & Hold- Baustein |
| 20 | Impulsgeber |
| 21 | Impulsgeber |
| 22 | Eingang des Mikrocontrollers |
| 23 | Ausgang des Mikrocontrollers |
| 24 | Eingang des Mikrocontrollers |
| 25 | Massepotential |
| 26 | Effektivwertanzeigeeinrichtung |

**Patentansprüche**

1. Verfahren zur Stromwertermittlung unter Einsatz eines Stromwandlers (1), welcher im Bereich der Kernsättigung arbeitet, wobei mittels eines Spitzenwertgleichrichters (12) ein Spitzen- bzw. Scheitelwert einer Halbwelle des Sekundärstromes ($I_{sek}$) ermittelt wird und der Spitzen- bzw. Scheitelwert in einem Speicherelement (15) zur Weiterverarbeitung gespeichert wird, **dadurch gekennzeichnet, dass**

   a) mittels eines Komparators (14) das Erreichen des Spitzen- bzw. Scheitelwertes detektiert wird, ein Schaltsignal beim Erreichen des Spitzen- bzw. Scheitelwertes vom Komparator (14) einer Signalverarbeitungseinheit (11) zugeführt wird, und dieses Signal die Signalverarbeitungseinheit (11) startet,
   b) die Signalverarbeitungseinheit (11) den im Speicherelement (15) gespeicherten Spitzen- bzw. Scheitelwert übernimmt und zur weiteren Bearbeitung bereitstellt, und
   c) danach an eine Schaltvorrichtung (16) von der Signalverarbeitungseinheit (11) oder einer dem Komparator nachgeschalteten Impulsgeberanordnung (20), (21) ein RESET- Impuls übermittelt wird, um das Speicherelement (15) für die Erfassung des nächsten Spitzen- bzw. Scheitelwertes zu entladen.

2. Verfahren nach Anspruch 1, **dadurch gekennzeichnet, daß** mittels eines Impulsgebers (20), welcher mittels des Komperators (14) getriggert wird, einen Impuls an die Signalverarbeitungseinheit (11) übermittelt, welche als Sample & Hold- Baustein (19) ausgeführt ist, und der im Speicherelement (15) gespeicherte Spitzen- bzw. Scheitelwert in einen Sample & Hold- Baustein (19) übernommen wird.

3. Verfahren nach Anspruch 2, **dadurch gekennzeichnet, daß** die negativen Flanke des Impulsgebers (20) einem nachgeschalteten Impulsgeber (21) zugeführt wird und der Impulsgeber (21) ein kurzzeitiges Schließen der Schaltvorrichtung (16) bewirkt, um damit den Speicherkondensator (15) zu entladen und die Bereitschaft für die Erfassung des nächsten Spitzen- bzw. Scheitelwertes herzustellen.

4. Verfahren nach einem der vorhergehenden Ansprüche, **dadurch gekennzeichnet, daß** der in der Signalverarbeitungseinheit (11) bereitgestellte Wert zur Berechnung der Motorschutzfunktion oder zur Effektivwertanzeige weiterverwendet wird.

5. Verfahren nach einem der vorhergehenden Ansprüche, **dadurch gekennzeichnet, daß** der Strom über der Schaltvorrichtung (16) mittels eines Widerstandes (17) begrenzt wird.

6. Einrichtung zur Stromwertermittlung, die einen Stromwandler (1) enthält, welcher im Bereich der Kernsättigung arbeitet, wobei im Sekundärzweig ein Spitzenwertgleichrichter (12) zur Ermittlung des Spitzen- bzw. Scheitelwertes einer Halbwelle des Siekundärstromes ($I_{sek}$) und ein Speicherelement (15) für die Speicherung des Spitzen- bzw. Scheitelwertes aus dem Spitzenwertgleichrichter (12) zur Weiterverarbeitung vorhanden sind, **dadurch gekennzeichnet, dass**

a) die in der Sekundärwicklung des Stromwandlers induzierte Spannung einen 90° nacheilenden Strom in der Induktivität erzeugt, der an einem zur Sekundärwicklung parallelgeschalteten Meßwiderstand (10) ein entsprechendes Signal für die elektronische Weiterverarbeitung bereitstellt,

b) ein Komperator (14) vorhanden ist, der das Erreichen des Spitzen- bzw. Scheitelwert aus dem Spitzenwertgleichrichter (12) detektiert und dieses Signal einer Signalverarbeitungseinheit (11) als Schaltsignal zuführt und die Signalverarbeitungseinheit (11) aktiviert, und

c) eine Schaltvorrichtung (16) vorhanden ist, die das Speicherelement für die fassung des nächsten Spitzen- bzw. Scheitelwertes mittels eines von der Signalverarbeitungseinheit (11) oder einer dem Komperator (14) nachgeschalteten Impulsgeberanordnung (20), (21) übermittelten RESET- Impulses entlädt.

**7.** Einrichtung nach Anspruch 6, **dadurch gekennzeichnet, daß** die Schaltvorrichtung (16) dafür eingerichtet ist, mittels eines von der Signalverarbeitungseinheit (11) erzeugten RESET- Signals kurzzeitig zu schließen und **dadurch** das Speicherelement (15) zu entladen.

**8.** Einrichtung nach Anspruch 6 oder 7, **dadurch gekennzeichnet, daß** der Schaltvorrichtung (16) ein Widerstand (17) nachgeschaltet ist, der dafür eingerichtet ist, den Strom über der Schaltvorrichtung (16) zu begrenzen.

**9.** Einrichtung nach Anspruch 6, 7 oder 8, **dadurch gekennzeichnet, daß** das Speicherelement (15) ein Speicherkondensator ist.

**10.** Einrichtung nach Anspruch 6, 7, 8 oder 9, **dadurch gekennzeichnet, daß** dem Komperator (14) ein erster Impulsgeber (20) nachgeschaltet ist und dessen Impuls einen Sample & Hold- Baustein (19) aktiviert, um den im Speicherelement (15) gespeicherte Spitzen- bzw. Scheitelwert zu übernehmen.

**11.** Einrichtung nach Anspruch 10, **dadurch gekennzeichnet, daß** der erste Impulsgeber (20) einen zweiten Impulsgeber (21) schaltet, der dafür eingerichtet ist, ein kurzzeitiges Schließen der Schaltvorrichtung (16) zu bewirken, um damit den Speicherkondensator (15) zu entladen und die Bereitschaft für die Erfassung des nächsten Spitzen- bzw. Scheitelwertes herzustellen.

**12.** Einrichtung nach Anspruch 6, 7, 8 oder 9, **dadurch gekennzeichnet, daß** die Signalverarbeitungseinheit (11) ein Mikrocontroller (18) mit integriertem Analog/Digital-Wandler ist, der dafür eingerichtet ist, nach erfolgter Analog/Digital- Wandlung das Ausgangssignal der Signalverarbeitungseinheit (11) weiterzuverarbeiten.

**13.** Einrichtung nach Anspruch 6, 7, 8, 9, 10, 11 oder 12, **dadurch gekennzeichnet, daß** das Ausgangssignal der Signalverarbeitungseinheit (11) zur Effektivwertanzeige einer Effektivwertanzeigeeinrichtung (26) zugeführt wird.

**14.** Einrichtung nach Anspruch 6, 7, 8, 9, 10, 11 oder 12, **dadurch gekennzeichnet, daß** die Signalverarbeitungseinheit (11) dafür eingerichtet ist, ein Signal für die Berechnung einer Motorschutzfunktion zur Verfügung zu stellen.

**15.** Einrichtung nach Anspruch 6, 7, 8, 9, 10, 11, 12, 13 oder 14, **dadurch gekennzeichnet, daß** der Spitzenwertgleichrichter (12) ein Präzisionsgleichrichter ist.

**Claims**

**1.** A method for determining the current value by using a current transformer (1) operating in the core saturation region, with a peak or crest value of a half-cycle of the secondary current ($I_{sek}$) being determined by means of a peak-value rectifier (12) and the peak or crest value being stored in a storage element (15) for further processing, **characterized in that**

a) the reaching of the peak or crest value is detected by means of a comparator (14), a switching signal is supplied on reaching the peak or crest value by the comparator (14) to a signal processing unit (11), and said signal starts the signal processing unit (11);

b) the signal processing unit (11) receives the peak or crest value stored in the storage element (15) and makes the same available for further processing, and

c) thereafter a RESET pulse is sent to a switching apparatus (16) by the signal processing unit (11) or a pulse generator arrangement (20, 21) series-connected with the comparator in order to discharge the storage element (15) for detecting the next peak or crest value.

**2.** A method according to claim 1, **characterized in that** a pulse is sent to the signal processing unit (11) by means of a pulse generator (20) which is triggered by means of the comparator (14), which signal processing unit is arranged as a sample & hold module (19), and the peak or crest value stored in the storage element (15) is received in a sample & hold module (19).

**3.** A method according to claim 2, **characterized in that** the negative flank of the pulse generator (20) is supplied to a series-connected pulse generator (21) and the pulse generator (21) causes a short-term closing of the switching apparatus (16) in order to thus discharge the storage capacitor (15) and to thus produce the readiness for detecting the next peak or crest value.

**4.** A method according to one of the preceding claims, **characterized in that** the value made available in the signal processing unit (11) is used further for calculating the motor protecting function or for displaying the effective value.

**5.** A method according to one of the preceding claims, **characterized in that** the current is limited via the switching apparatus (16) by means of a resistor (17).

**6.** A device for determining the current value, comprising a current transformer (1) operating in the region of core saturation, with a peak-value rectifier (12) being present in the secondary branch for determining the peak or crest value of a half-cycle of the secondary current ($I_{sek}$) and a storage element (15) being present for the storage of the peak or crest value from the peak-value rectifier (12) for further processing, **characterized in that**

a) the voltage induced in the secondary winding of the current transformer produces in the inductivity a current which lags 90° and which provides a respective signal for electronic further processing in a measuring resistor (10) switched in parallel to the secondary winding;
b) a comparator (14) is present which detects reaching the peak or crest value from the peak-value rectifier (12) and supplies this signal of a signal processing unit (11) as a switching signal and activates the signal processing unit (11), and
c) a switching arrangement (16) is present which discharges the storage element for the detection of the next peak or crest value by means of a RESET pulse sent by the signal processing unit (11) or a pulse generator arrangement (20, 21) series-connected with the comparator (14).

**7.** A device according to claim 6, **characterized in that** the switching apparatus (16) is configured to close for a short time by means of a RESET pulse generated by the signal processing unit (11) and to thus discharge the storage element (15).

**8.** A device according to claim 6 or 7, **characterized in that** a resistor (17) is series-connected with the switching apparatus (16), which resistor is configured to limit the current via the switching apparatus (16).

**9.** A device according to claim 6, 7 or 8, **characterized in that** the storage element (15) is a storage capacitor.

**10.** A device according to claim 6, 7, 8 or 9, **characterized in that** a first pulse generator (20) is series-connected with the comparator (14) and whose pulse activates a sample & hold module (19) in order to receive the peak or crest value stored in the storage element (15).

**11.** A device according to claim 10, **characterized in that** the first pulse generator (20) switches a second pulse generator (21) which is configured to cause a brief closing of the switching apparatus (16) in order to thus discharge the storage capacitor (15) and to produce the readiness for detecting the next peak or crest value.

**12.** A device according to claim 6, 7, 8 or 9, **characterized in that** the signal processing unit (11) is a microcontroller (18) with integrated analog-to-digital converter which is configured to further process the output signal of the signal processing unit (11) after performed analog-to-digital conversion.

**13.** A device according to claim 6, 7, 8, 9, 10, 11 or 12, **characterized in that** the output signal of the signal processing unit (11) is supplied for displaying the effective value of an effective-value display device (26).

**14.** A device according to claim 6, 7, 8, 9, 10, 11 or 12, **characterized in that** the signal processing unit (11) is configured to provide a signal for calculating a motor protecting function.

**15.** A device according to claim 6, 7, 8, 9, 10, 11, 12, 13 or 14, **characterized in that** the peak-value rectifier (12) is a precision rectifier.

**Revendications**

**1.** Procédé pour déterminer la valeur de l'intensité d'un courant en utilisant un transformateur (1) fonctionnant dans la zone de la saturation du noyau, selon lequel au moyen d'un redresseur de valeur de pointe (12) est établie une valeur de pointe ou de crête d'une demi-onde de l'intensité secondaire ($I_{sek}$) qui est enregistrée pour traitement ultérieur dans un élément de stockage (15), **caractérisé en ce que**

a) un comparateur (14) détecte que la valeur de pointe ou de crête est atteinte, et envoie alors à une unité de traitement de signal (11) un signal de commutation qui met en marche cette unité de traitement (11),
b) l'unité de traitement de signal (11) reçoit la valeur de pointe ou de crête enregistrée dans l'élément de stockage (15) et la prépare pour un traitement ultérieur,
c) ensuite à un dispositif de commutation (16) est adressée, par l'unité de traitement de signal (11) ou par un système générateur d'impulsions (20, 21) monté en aval du comparateur, une impulsion de remise à zéro afin de décharger l'élément de stockage (15) en vue de la saisie de la prochaine valeur de pointe ou de crête.

**2.** Procédé selon la revendication 1, **caractérisé en ce qu'**un générateur d'impulsions (20) que déclenche le comparateur (14), transmet une impulsion à l'unité de traitement de signal (11) constituée par un module de Sample & Hold (19) dans lequel est reçue la valeur de pointe ou de crête mémorisée dans l'élément de stockage (15).

**3.** Procédé selon la revendication 2, **caractérisé en ce que** le flanc négatif du générateur d'impulsions (20) est envoyé à un générateur d'impulsions (21) disposé en aval et qui produit une brève fermeture du dispositif de commutation (16) afin de décharger ainsi le condensateur de stockage (15) et de le rendre prêt à saisir la prochaine valeur de pointe ou de crête.

**4.** Procédé selon une des revendications précédentes, **caractérisé en ce que** la valeur préparée dans l'unité de traitement de signal (11) est utilisée ensuite pour calculer la fonction de protection du moteur ou pour afficher la valeur effective.

**5.** Procédé selon une des revendications précédentes, **caractérisé en ce que** le courant est délimité dans le dispositif de commutation (16) au moyen d'une résistance (17).

**6.** Dispositif pour déterminer une valeur d'intensité, comprenant un transformateur de courant (1) qui fonctionne dans la zone de saturation du noyau, avec dans la branche secondaire un redresseur de valeur de pointe (12) pour déterminer la valeur de pointe ou de crête d'une demi-onde de l'intensité secondaire $I_{sek}$, ainsi qu'un élément de stockage (15) pour enregistrer cette valeur issue du redresseur (12) en vue d'un traitement extérieur, **caractérisé en ce que**

a) la tension induite dans l'enroulement secondaire du transformateur produit dans l'inductance une tension décalée en retard de 90° et qui établit sur une résistance de mesure (10) montée en parallèle avec l'enroulement secondaire un signal correspondant pour le traitement électronique ultérieur,
b) un comparateur détecte qu'est atteinte la valeur de pointe ou de crête issue du redresseur de valeur de pointe (12) et envoie un signal à une unité de traitement de signal (11) en tant que signal d'enclenchement qui active cette unité de traitement de signal (11),
c) il y a un dispositif de commutation (16) qui décharge l'élément de stockage afin qu'il saisisse la prochaine valeur de pointe ou de crête au moyen d'une impulsion de remise à zéro transmise par l'unité de traitement de signal (11) ou par un système générateur d'impulsions (20, 21) monté en aval du comparateur (14).

**7.** Dispositif selon la revendication 6, **caractérisé en ce que** le dispositif de commutation (16) est conçu pour se fermer brièvement par l'intermédiaire d'un signal de remise à zéro produit par l'unité de traitement de signal (11) et décharger ainsi l'élément de stockage (15).

**8.** Dispositif selon la revendication 6 ou 7, **caractérisé en ce qu'**en aval du dispositif de commutation (16) est montée une résistance (17) conçue pour limiter le courant dans le dispositif de commutation (16).

**9.** Dispositif selon la revendication 6, 7 ou 8, **caractérisé en ce que** l'élément de stockage (15) est un condensateur de stockage.

**10.** Dispositif selon la revendication 6, 7, 8 ou 9, **caractérisé en ce qu'**en aval du comparateur (14), est monté un générateur d'impulsion (20) dont l'impulsion active un module de Sample & Hold (19) pour recevoir la valeur de pointe ou de crête mémorisée dans l'élément de stockage (15).

**11.** Dispositif selon la revendication 10, **caractérisé en ce que** le premier générateur d'impulsion (20) enclenche un second générateur d'impulsion (21) qui est conçu pour fermer brièvement le dispositif de commutation (16), afin de décharger ainsi le condensateur de stockage (15) et de le rendre prêt à saisir la prochaine valeur de pointe ou de crête.

**12.** Dispositif selon la revendication 6, 7, 8 ou 9, **caractérisé en ce que** l'unité de traitement de signal (11) est un microcontrôleur (18) intégrant un convertisseur analogique/digital et qui est conçu pour, une fois la conversion analogique/digitale effectuée, assurer un traitement complémentaire du signal de sortie de l'unité de traitement de signal (11).

**13.** Dispositif selon la revendication 6, 7, 8, 9, 10, 11 ou 12, **caractérisé en ce que** le signal de sortie de l'unité de traitement de signal (11) est envoyé pour affichage de valeur effective à un dispositif d'affichage de valeur effective (26) .

**14.** Dispositif selon la revendication 6, 7, 8, 9, 10, 11 ou 12, **caractérisé en ce que** l'unité de traitement de signal (11) est conçue pour mettre à disposition un signal destiné au calcul d'une fonction de protection de moteur.

**15.** Dispositif selon la revendication 6, 7, 8, 9, 10, 11, 12, 13 ou 14, **caractérisé en ce que** le redresseur de valeur de pointe (12) est un redresseur de précision.

Fig. 1

Fig. 2

Fig. 3